# FASCICULE DE BREVET EUROPEEN

(11) **EP 2 279 559 B1**
(45) Date de publication et mention de la délivrance du brevet: **22.06.2011**
(21) Numéro de dépôt: 09730355.6
(22) Date de dépôt: 11.03.2009
(51) Int. Cl.: H03K 17/687, H03K 17/082, H02H 3/02

(54) **SYSTÈME À RELAIS STATIQUE COMPRENANT DEUX TRANSISTORS DE TYPE JFET EN SÉRIE**
RELAISSYSTEM MIT ZWEI JFET-TRANSISTOREN IN REIHE
RELAY SYSTEM COMPRISING TWO JFET TRANSISTORS IN SERIES

(30) Priorité: 09.04.2008 FR 0852367
(43) Date de publication de la demande: 02.02.2011
(73) Titulaire: Schneider Electric Industries SAS, 92500 Rueil-Malmaison (FR)
(72) Inventeur: BOUDET, Thierry, F-38130 Echirolles (FR); CARCOUET, Sébastien, F-38450 Vif (FR)
(74) Mandataire: Bié, Nicolas
(86) Numéro de dépôt international: PCT/EP2009/052845
(87) Numéro de publication internationale: WO 2009/124818

(56) Documents cités:
- WO-A-93/11608
- DE-A1- 19 725 870
- DE-A1-102006 022 158
- US-A- 3 873 887
- US-A- 5 008 565
- US-A1- 2006 049 426
- JAMES A COOPERJR ET AL: "SiC Power-Switching Devices-The Second Electronics Revolution?" PROCEEDINGS OF THE IEEE, IEEE. NEW YORK, US, vol. 90, no. 6, 1 juin 2002 (2002-06-01), XP011065017 ISSN: 0018-9219

## Description

La présente invention se rapporte à un système relais statique destiné à être connecté en série avec une charge électrique alimenté en courant alternatif.

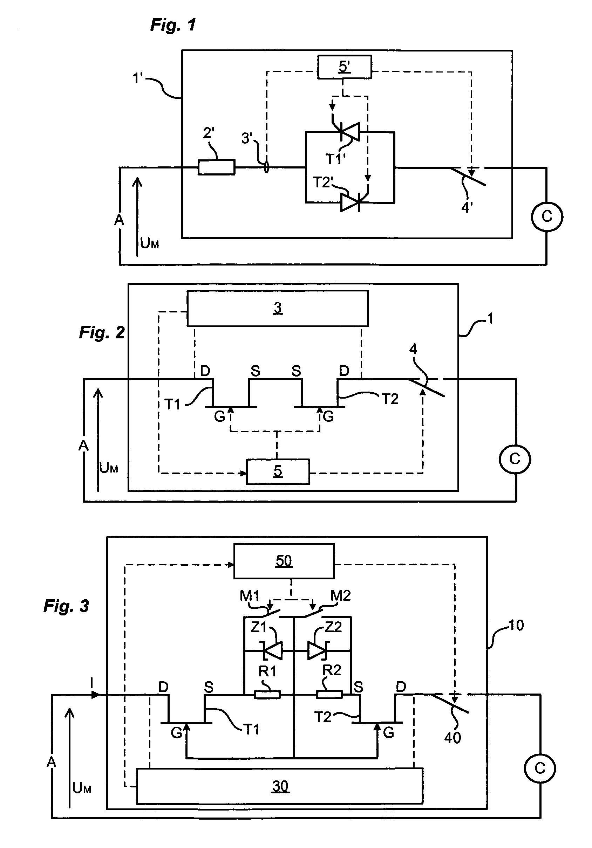

Il existe des systèmes à relais statiques 1' (appelés également "Solid State Relay" ou SSR) tels que représentés en figure 1 intégrant notamment des interrupteurs de puissance de type thyristors T1', T2', un fusible 2' ou un disjoncteur pour protéger les interrupteurs, un capteur de courant 3' et un relais électromécanique 4'. Des moyens de commande 5' permettent de commander les thyristors et de commander le relais électromécanique 4' à l'ouverture lorsque l'intensité du courant mesurée par le capteur de courant 3' dépasse un seuil déterminé. Ce type de système présente les inconvénients suivants :
- la dissipation thermique des deux thyristors T1', T2' est importante de sorte que l'emploi d'un dissipateur pour refroidir les composants est nécessaire. Le relais est donc particulièrement encombrant,
- le fusible 2' ou un disjoncteur est nécessaire pour protéger le circuit. Après un court-circuit, le fusible doit être remplacé ou le disjoncteur doit être réarmé,
- le capteur de courant 3' est un élément particulièrement coûteux.

Un autre système à relais statique est décrit dans WO 93/11608.

Le but de l'invention est de proposer un système à relais statique simple, peu coûteux, qui ne nécessite pas une intervention après un court-circuit et dans lequel la dissipation thermique est faible.

Ce but est atteint par un système à relais statique destiné à être connecté en série avec une charge électrique alimenté en courant alternatif comme défini dans la revendication 1.

Selon une particularité, les deux transistors de type JFET sont reliés par leur source.

Selon une autre particularité, les transistors sont fabriqués en carbure de silicium ou en nitrure de gallium.

Selon une autre particularité, le système comporte également deux diodes Zener de limitation connectées en parallèle des résistances de polarisation.

Les interrupteurs de commande sont par exemple des transistors de type MOSFET dont les sources sont connectées entre elles et aux grilles des transistors et dont les drains sont reliés à la source d'un transistor correspondant. La grille de chaque transistor MOSFET est alors connectée aux moyens de commande via une résistance de grille. En variante de réalisation, les interrupteurs de commande sont par exemple des micro-interrupteurs de type MEMS commandés à l'aide d'une bobine alimentée par les moyens de commande.

D'autres caractéristiques et avantages vont apparaître dans la description détaillée qui suit en se référant à un mode de réalisation donné à titre d'exemple et représenté par les dessins annexés sur lesquels :
- la figure 1 représente un système à relais statique selon l'art antérieur connecté à une charge électrique,
- la figure 2 représente un système à relais statique alternatif connecté à une charge électrique, dans lequel les transistors sont de type normalement ouvert,
- la figure 3 représente un système à relais statique selon l'invention connecté à une charge électrique, dans lequel les transistors sont de type normalement fermé.

La figure 1 a déjà été décrite ci-dessus.

En référence aux figures 2 et 3, le système à relais statique 1, 10 est destiné à commander une charge électrique C alimenté en courant alternatif à partir d'une source d'alimentation A.

Le système à relais statique 1, 10 comporte deux transistors à effet de champ T1 et T2 bidirectionnels, par exemple identiques, montés en série, plus précisément en anti-série ou autrement dit tête-bêche, et réalisés dans un matériau à grande énergie de bande interdite (appelé également "matériau à grand gap" ou "wide-band gap material"), c'est-à-dire présentant une faible résistance à l'état passant R_{DSon} et capable de supporter des tensions importantes (supérieures à 1000 V), comme par exemple le carbure de silicium ou le nitrure de gallium (GaN).

Ces transistors à effet de champ T1, T2 sont de type JFET ("Junction Field Effect Transistor"). Un transistor JFET est un interrupteur électronique de puissance connu qui comporte une Grille de commande (G) dont la fonction est d'autoriser ou non le passage d'un courant entre un Drain (D) et une Source (S). Un tel transistor est dit de type normalement fermé (ou "anormal ON") si le chemin Drain-Source est passant ou conducteur en l'absence de tension de commande V_{GS} entre Grille et Source. Inversement, un transistor JFET est dit du type normalement ouvert (ou "normally OFF") si le chemin Drain-Source n'est pas conducteur en l'absence de tension V_{GS} entre Grille et Source.

Des moyens de commande 5, 50 permettent d'appliquer sur les grilles (G) des deux transistors une même tension V_{GS} pour commander simultanément les deux transistors à l'ouverture ou à la fermeture.

Le système à relais statique 1, 10 comporte par ailleurs un relais, par exemple de type électromécanique commandé par les moyens de commande en fonction d'une tension mesurée aux bornes de chacun des transistors T1 et T2 ou aux bornes des deux transistors T1 et T2 en même temps. Si une surcharge de courant est détectée, le relais électromécanique 4, 40 est commandé à l'ouverture pour protéger les transistors. Pour cela, des moyens de détection 3, 30 d'un seuil de tension sont montés en parallèle de chacun des deux transistors T1 ou T2 ou des deux transistors T1, et T2 (comme sur les figures 2 et 3) pour détecter la surcharge en courant traversant les transistors. En effet, lorsque le courant qui traverse un transistor JFET est supérieur à son courant de limitation, le transistor passe en limitation entraînant une augmentation de sa résistance interne. De ce fait, la tension aux bornes du transistor augmente également. Les moyens de détection 3, 30 du seuil de tension comportent par exemple un ensemble constitué d'une résistance, d'un optocoupleur et d'une diode transil ou Zener montés en série, cet ensemble étant monté en parallèle de chacun des transistors ou des deux transistors en série. En variante de réalisation, il est possible de prévoir l'ouverture de l'un des transistors ou des deux transistors lorsque la surcharge en courant est détectée. Dans ce cas, le relais électromécanique 4, 40 peut être ouvert ultérieurement, juste pour assurer l'isolation galvanique du circuit.

Sur la figure 2, les deux transistors JFETs T1, T2 utilisés sont de type normalement ouvert. Les deux transistors T1, T2 sont connectés entre eux par leurs Sources (S), le Drain (D) du premier transistor T1 est connecté à la source d'alimentation A tandis que le Drain (D) du second transistor T2 est connecté à la charge C. Les moyens de commande 5 appliquent directement une même tension V_{GS} sur les deux grilles (G) des transistors T1, T2 pour les commander à la fermeture.

Sur la figure 3, les deux transistors JFETs T1, T2 du système à relais statique 10 selon l'invention sont de type normalement fermé. Actuellement, un transistor JFET fabriqué dans un matériau à grande énergie de bande interdite et de type normalement fermé offre de meilleures performances que d'autres types de transistors commandés en tension, tels que des MOSFET, des IGBT ou même des transistors JFET de type normalement ouvert. En effet, un tel transistor présente notamment les avantages d'être plus rapide à commuter, de générer moins de pertes en conduction à l'état passant (faible résistance R_{DSon} à l'état passant), d'avoir une meilleure tenue en température et d'avoir une taille plus petite.

Lorsque les deux transistors T1, T2 sont de type normalement fermé, il est cependant nécessaire de prévoir un dispositif permettant de maintenir le circuit ouvert en l'absence d'un signal de commande envoyé par les moyens de commande.

Le système à relais statique 10 comporte ainsi deux résistances de polarisation R1 et R2 et deux interrupteurs de commande M1 et M2 commandés par les moyens de commande 50. Les transistors T1 et T2 ont leur Grille (G) qui sont reliées entre elles. Les transistors T1, T2 sont montés tête-bêche en série avec la charge C de telle sorte que le Drain (D) du transistor T1 soit relié au réseau alternatif, le Drain (D) du transistor T2 soit relié à une extrémité de la charge C, et les Sources (S) des transistors T1, T2 soient reliées ensemble au travers des résistances de polarisation R1, R2. Chaque résistance R1, respectivement R2, est donc connectée entre la Grille et la Source d'un transistorT1, respectivement T2. De préférence, les transistors T1 et T2 sont identiques, de même que les résistances R1 et R2.

Chaque interrupteur de commande M1, respectivement M2, est connecté en parallèle d'une des résistances de polarisation R1, respectivement R2. Les interrupteurs de commande M1, M2 peuvent être des composants électromécaniques, tels que des mini-relais ou des MEMS (Micro Electro Mechanical Switch), ou préférentiellement des composants électroniques semi-conducteurs tels que des transistors MOSFET basse tension. Dans le cas de composants électromécaniques, les moyens de commande envoient un signal de commande dans des bobines d'excitation de M1 et M2. Dans le cas de composants électroniques semi-conducteurs, ce signal de commande est envoyé sur les Grilles des composants M1 et M2, via une résistance de grille.

Le système à relais statique 10 peut également comporter deux diodes Zener de protection Z1 et Z2 identiques qui sont connectées en parallèle des résistances de polarisation R1 et R2. La cathode de Z1, respectivement Z2, est reliée à la Source du transistor T1, respectivement T2, et l'anode de Z1, respectivement Z2, est reliée à la Grille du transistor T1, respectivement T2. Ces diodes Zener protègent les transistors JFET car elles permettent de toujours limiter les tensions Grille - Source V_{GS} entre leur tension zener V_{Z} (ou tension de claquage) dans un sens (de l'ordre de par exemple -15 V) et leur chute de tension directe dans l'autre sens (par exemple +0,7 V).

Le fonctionnement du mode de réalisation de la figure 3 est le suivant :
a. On suppose au départ que la tension réseau U_{M} est nulle (le relais 40 est ouvert), donc les tensions entre Grille et Source V_{GS1}, respectivement V_{GS2}, des transistors JFET T1, respectivement T2, sont nulles, ce qui fait que ceux-ci sont fermés, car les transistors T1 et T2 sont de type normalement fermé. On suppose également qu'il n'y a pas de signal de commande envoyé par les moyens de commande 50 et donc que les interrupteurs de commande M1, M2 sont à l'état ouvert (non-passant).
b. Lors de l'apparition d'une tension réseau U_{M} (le relais 40 est fermé), par exemple une arche dite positive, un courant I commence à circuler dans T1, R1, R2, T2 dans le sens indiqué par la flèche sur la figure 3. Ce courant I génère très rapidement une tension V_{R1} positive aux bornes de la résistance R1. Comme V_{R1} = -V_{GS1} par construction, la tension V_{R1} positive crée une tension V_{GS1} négative entre Grille et Source du transistor JFET T1. La valeur de R1 est choisie de façon à ce que V_{GS1} atteigne rapidement la tension de blocage (ou tension de pincement) V_{P} permettant de faire basculer le transistor JFET T1 à l'état ouvert (non-passant). Le courant traversant R1 chute alors jusqu'à ce que V_{GS1} repasse au-dessus de la tension de blocage V_{P}, ce qui rend le transistor JFET T1 de nouveau légèrement passant. Le courant I va donc réaugmenter jusqu'à ce que V_{R1} atteigne de nouveau la tension de blocage V_{P} de façon à rebloquer T1, et ainsi de suite. Durant cette arche positive, le transistor JFET T1 est monté en source de courant, le courant étant ainsi fixé par la résistance R1 et la tension de blocage V_{P}.

Ainsi, l'agencement de T1 et R1 fait que durant une arche positive, le courant I est inférieur ou égal à un courant résiduel de valeur très faible Iₘᵢₙ, très insuffisant pour alimenter correctement la charge C.

Par ailleurs, durant cette arche positive, la diode Zener Z1 est bloquée et la diode Zener Z2 est passante. La tension V_{Z2} aux bornes de Z2 est donc égale à la chute de tension directe d'une diode Zener (généralement de l'ordre de 0,7 V), ce qui permet de limiter la tension V_{R2} aux bornes de R2 et donc de limiter la valeur positive de la tension V_{GS2}, de façon à éviter des problèmes de Grille pour le transistor T2.
c. Durant l'arche suivante négative, le courant I change de sens et le fonctionnement est similaire à celui décrit ci-dessus avec la résistance R2 et le transistor JFET T2. Le courant I circulant en sens négatif entraîne très rapidement une tension V_{R2} positive aux bornes de la résistance R2. Comme V_{R2} = -V_{GS2} par construction, la tension V_{R2} positive crée une tension V_{GS2} négative entre Grille et Source du transistor JFET T2. La valeur de R2 est choisie de façon à ce que V_{GS2} atteigne rapidement la tension de blocage V_{P} permettant de faire basculer le transistor JFET T2 à l'état ouvert (non-passant). Durant cette arche négative, le transistor JFET T2 est monté en source de courant, le courant étant ainsi fixé par la résistance R2 et la tension de blocage V_{P}.

Ainsi, en l'absence de signal de commande sur les interrupteurs de commande M1, M2, le courant I circulant dans la charge C reste en permanence inférieur ou égal à Iₘᵢₙ, ce qui permet d'assurer en toute sécurité que la charge électrique n'est pas commandée en l'absence de signal de commande.
d. Lors de l'apparition d'un signal de commande, les interrupteurs de commande M1 et M2 se ferment, ce qui a pour effet de shunter les résistances R1 et R2. Les tensions V_{R1}, V_{R2} deviennent donc pratiquement nulles (de l'ordre de quelques dizaine de millivolts seulement), car V_{R1} = R_{onM1} * I, dans lequel R_{onM1} est la résistance à l'état passant du transistor MOSFET M1 basse tension qui est très faible et I est le courant circulant dans la charge C. Ceci a pour conséquence de forcer également les tensions Grille-Source V_{GS1} et V_{GS2} des transistors T1 et T2 à zéro. Les transistors T1 et T2 deviennent alors tous les deux passants et la charge électrique C est alimentée, quel que soit le sens du courant I.

Avantageusement, lors de l'apparition d'un défaut de courant, tel que par exemple un court-circuit les deux transistors T1 et T2 peuvent passer en saturation à partir d'un certain niveau de courant pour ainsi limiter le courant à une valeur faible, nettement inférieure à un courant de défaut.

Il est bien entendu que l'on peut imaginer d'autres variantes et perfectionnements de détail et de même envisager l'emploi de moyens équivalents, sans sortir du cadre de l'invention, tel que défini dans les revendications suivantes.

## Revendications

1. Système à relais statique (1, 10) destiné à être connecté en série avec une charge électrique (C) alimenté en courant alternatif comprenant:
- deux transistors (T1, T2) bidirectionnels de type JFET normalement fermé montés en série dont les grilles (G) sont connectées entre elles, fabriqués dans un matériau à grande énergie de bande interdite et pouvant fonctionner en limitation de courant,
- des moyens de détection (3, 30) d'un seuil d'une tension aux bornes de chacun des transistors ou des deux transistors (T1, T2),
- un relais électromécanique (4, 40) monté en série avec les transistors (T1, T2),
- des moyens de commande (5, 50) pour commander à l'ouverture au moins un transistor ou le relais électromécanique lorsque le seuil de tension est dépassé,
- deux résistances de polarisation (R1, R2), chaque résistance de polarisation étant reliée respectivement entre la grille (G) et la source (S) d'un des transistors de puissance,
- deux interrupteurs de commande (M1, M2) commandés par les moyens de commande (50), chaque interrupteur de commande (M1, M2) étant respectivement connecté en parallèle d'une des résistances de polarisation (R1, R2).

2. Système à relais statique selon la revendication 1, dans lequel les deux transistors de type JFET sont reliés par leur source (S).

3. Système à relais statique selon la revendication 1 ou 2, dans lequel les transistors (T1, T2) sont fabriqués en carbure de silicium.

4. Système à relais statique selon la revendication 1 ou 2, dans lequel les transistors (T1, T2) sont fabriqués en nitrure de gallium.

5. Système à relais statique selon la revendication 1, qui comporte également deux diodes Zener (Z1, Z2) de limitation connectées en parallèle des résistances de polarisation (R1, R2).

6. Système à relais statique selon la revendication 5, dans lequel les interrupteurs de commande (M1, M2) sont des transistors de type MOSFET dont les sources (S) sont connectées entre elles et aux grilles (G) des transistors (T1, T2) et dont les drains (D) sont reliés à la source d'un transistor (T1, T2) correspondant.

7. Système à relais statique selon la revendication 6, dans lequel grille (G) de chaque transistor MOSFET est connectée aux moyens de commande via une résistance de grille.

8. Système à relais statique selon la revendication 5, dans lequel les interrupteurs de commande (M1, M2) sont des micro-interrupteurs de type MEMS commandés à l'aide d'une bobine alimentée par les moyens de commande (50).

## Claims

1. A solid-state relay system (1, 10) intended to be connected in series with an electrical load (C) powered by alternative current, comprising:
- two series-mounted bidirectional transistors (T1, T2) of normally-on JFET type, the gates (G) of which are connected together, made of a wide bandgap material and able to operate in current limiting mode,
- means (3, 30) for detecting a threshold of a voltage at the terminals of each of the transistors or of both transistors (T1, T2),
- an electromechanical relay (4, 40) mounted in series with the transistors (T1, T2),
- control means (5, 50) for switching off at least one transistor or the electromechanical relay when the voltage threshold is exceeded,
- two biasing resistors (R1, R2), each biasing resistor being respectively linked between the gate (G) and the source (S) of one of the power transistors,
- two control switches (M1, M2) controlled by the control means (50), each control switch (M1, M2) being respectively connected in parallel with one of the biasing resistors (R1, R2).

2. The solid-state relay system as claimed in claim 1, in which both JFET-type transistors are linked by their source (S).

3. The solid-state relay system as claimed in claim 1 or 2, in which the transistors (T1, T2) are made of silicon carbide.

4. The solid-state relay system as claimed in claim 1 or 2, in which the transistors (T1, T2) are made of gallium nitride.

5. The solid-state relay system as claimed in claim 1, which also comprises two limiting Zener diodes (Z1, Z2) connected in parallel with the biasing resistors (R1, R2).

6. The solid-state relay system as claimed in claim 5, in which the control switches (M1, M2) are MOSFET-type transistors, the sources (S) of which are connected together and to the gates (G) of the transistors (T1, T2) and the drains (D) of which are linked to the source of a corresponding transistor (T1, T2).

7. The solid-state relay system as claimed in claim 6, in which the gate (G) of each MOSFET transistor is connected to the control means via a gate resistor.

8. The solid-state relay system as claimed in claim 5, in which the control switches (M1, M2) are MEMS-type microswitches controlled using a coil powered by the control means (50).

## Patentansprüche

1. System (1, 10) mit statischem Relais, das dazu bestimmt ist, mit einer mit Wechselstrom versorgten elektrischen Last (C) in Reihe geschaltet zu werden, und umfasst:
- zwei bidirektionale Transistoren (T1, T2) des normalerweise geschlossenen JFET-Typs, die in Reihe geschaltet sind und deren Gates (G) miteinander verbunden sind, die aus einem Material mit großem Bandabstand hergestellt sind und im Strombegrenzungsbetrieb arbeiten können,
- Mittel (3, 30) zum Detektieren einer Spannungsschwelle an den Anschlüssen jedes der Transistoren oder der zwei Transistoren (T1, T2),
- ein elektromechanisches Relais (4, 40), das mit den Transistoren (T1, T2) in Reihe geschaltet ist,
- Steuermittel (5, 50), um das Öffnen wenigstens eines Transistors oder des elektromechanischen Relais zu steuern, wenn der Spannungsschwellenwert überschritten wird,
- zwei Vorspannungswiderstände (R1, R2), wobei jeder Vorspannungswiderstand zwischen das Gate (G) und die Source (S) eines Entsprechenden der Leistungstransistoren geschaltet ist,
- zwei Steuerunterbrecher (M1, M2), die durch die Steuermittel (50) gesteuert werden, wobei jeder Steuerunterbrecher (M1, M2) mit einem Entsprechenden der Vorspannungswiderstände (R1, R2) parallelgeschaltet ist.

2. System mit statischem Relais nach Anspruch 1, wobei die zwei Transistoren des JFET-Typs durch ihre Source (S) miteinander verbunden sind.

3. System mit statischem Relais nach Anspruch 1 oder 2, wobei die Transistoren (T1, T2) aus Siliciumcarbid hergestellt sind.

4. System mit statischem Relais nach Anspruch 1 oder 2, wobei die Transistoren (T1, T2) aus Galliumnitrid hergestellt sind.

5. System mit statischem Relais nach Anspruch 1, das außerdem zwei Begrenzungs-Zener-Dioden (Z1, Z2) enthält, die zu den Vorspannungswiderständen (R1, R2) parallelgeschaltet sind.

6. System mit statischem Relais nach Anspruch 5, wobei die Steuerunterbrecher (M1, M2) Transistoren des MOSFET-Typs sind, deren Sources (S) miteinander und mit den Gates (G) der Transistoren (T1, T2) verbunden sind und deren Drains (D) mit der Source eines entsprechenden Transistors (T1, T2) verbunden sind.

7. System mit statischem Relais nach Anspruch 6, wobei das Gate (G) jedes MOSFET-Transistors mit den Steuermitteln über einen Gate-Widerstand verbunden ist.

8. System mit statischem Relais nach Anspruch 5, wobei die Steuerunterbrecher (M1, M2) Mikrounterbrecher des MEMS-Typs sind, die mit Hilfe einer Spule gesteuert werden, die durch die Steuermittel (50) versorgt wird.
